# EUROPEAN PATENT APPLICATION

(11) **EP 4 618 413 A1**
(43) Date of publication of application: **17.09.2025**
(21) Application number: 24163801.4
(22) Date of filing: 15.03.2024
(51) Int. Cl.: H03G 3/00

(54) **A VARIABLE GAIN ARRANGEMENT**

(71) Applicant: NXP B.V., 5656 AG Eindhoven (NL)
(72) Inventor: BREKELMANS,, Johannes Hubertus Antonius, 5656 AG Eindhoven (NL); JANSSEN,, Erwin Johannes Gerardus, 5656 AG Eindhoven (NL); BURDIEK,, Bernard, 5656 AG Eindhoven (NL)
(74) Representative: Hardingham, Christopher Mark

(57) **Abstract**

A variable gain arrangement of a receiver path configured to receive an input signal and apply a gain to the input signal to provide an output signal, comprising: an input capacitor arrangement comprising a first input capacitor; a feedback capacitor arranged in series with the input capacitor arrangement, wherein the gain is based on a ratio of the first input capacitor and the feedback capacitor; and a gain switching apparatus configured to provide for adjustment of the gain applied to the input signal by changing the ratio; an amplifier in series with the input capacitor arrangement, the amplifier arranged in parallel with the feedback capacitor, the amplifier configured to provide the output signal; and a transient compensation capacitor arrangement comprising a first transient compensation capacitor, wherein, upon a change in the gain, the at least one transient compensation capacitor is configured to be coupled to or decoupled from the feedback capacitor such that transient settling effects caused by the gain change are compensated.

## Description

### Field

The present disclosure relates to a variable gain arrangement. The disclosure further relates to: a gain arrangement that comprises both the variable gain arrangement and a fixed gain arrangement; a radar system that comprises the gain arrangement; and an automotive vehicle that comprises the radar system.

### Summary

According to a first aspect of the present disclosure, there is provided a variable gain arrangement of a receiver path configured to receive an input signal and apply a gain to the input signal to provide an output signal, the variable gain arrangement comprising: an input capacitor arrangement through which the input signal is transmitted comprising a first input capacitor; a feedback capacitor arranged in series with the input capacitor arrangement, wherein the gain applied by the variable gain arrangement is based on a ratio of the first input capacitor and the capacitance of the feedback capacitor and a gain switching apparatus configured to provide for adjustment of the gain applied to the input signal by changing the ratio of the capacitance of the feedback capacitor and the input capacitor arrangement;
an amplifier arranged in series with the input capacitor arrangement, wherein the amplifier is further arranged in parallel with the feedback capacitor and wherein the amplifier is configured to provide the output signal; and a transient compensation capacitor arrangement comprising at least a first transient compensation capacitor, wherein, upon a change in the gain of the variable gain arrangement, the at least one transient compensation capacitor is configured to be coupled to or decoupled from the feedback capacitor such that transient settling effects caused by the gain change are compensated.

In one or more embodiments, the input capacitor arrangement may be the gain switching apparatus and wherein the input capacitor arrangement further comprises: a second input capacitor arranged in parallel with the first input capacitor; and a coupled input capacitor wherein the coupled input capacitor is the capacitor through which the input signal is transmitted, wherein the first input capacitor and the second input capacitor are switchably arranged such that the functionality of the coupled input capacitor is switchably provided by one of the first input capacitor and the second input capacitor.

In one or more embodiments, the transient compensation capacitor arrangement may comprise a plurality of transient compensation capacitors wherein, upon a change in the gain applied by the variable gain arrangement, the interconnections of the plurality of capacitors of the transient compensation capacitor arrangement with the feedback capacitor are dynamically reconfigured in order to provide for the transient settling effect compensation.

In one or more embodiments, the first transient compensation capacitor may be a current injection capacitor switchably couplable to the feedback capacitor, wherein the current injection capacitor is configured to, upon a change in the gain of the output signal, be coupled to the feedback capacitor such that charge is injected onto the feedback capacitor wherein the charge injection provides for the transient settling effect compensation.

In one or more embodiments, the first input capacitor and the second input capacitor may have different capacitances such that switching between the first input capacitor and the second input capacitor to define the coupled input capacitor causes the change in gain of the gain applied by the variable gain arrangement.

In one or more embodiments, the input capacitor arrangement may comprise: a first input path which comprises the first input capacitor; and a second input path which comprises the second input capacitor wherein the first input path is arranged in parallel with the second input path and wherein the first input path and the second input path are switchably couplable between: the amplifier; and a first voltage.

In one or more embodiments, the variable gain arrangement may further comprise a filtering resistor arranged in parallel with both the amplifier and the feedback capacitor wherein the filtering capacitor is configured to provide low frequency filtering of the input signal.

In one or more embodiments, the current injection capacitor may be coupled to the first voltage such that, when not coupled to the feedback capacitance arrangement, the injection capacitor is charged by the first voltage.

In one or more embodiments the current injection capacitor may be a first current injection capacitor coupled to a first node of the feedback capacitor and wherein the transient compensation capacitor arrangement comprises a second current injection capacitor coupled to a second node of the feedback capacitor, wherein the second a current injection capacitor is switchably couplable to the feedback capacitor, wherein: in response to an increase of the gain of the variable gain arrangement, the feedback capacitor is configured to be coupled to the feedback capacitor; and in response to a decrease of the gain of the variable gain arrangement, the second feedback capacitor is configured to be coupled to the feedback capacitor.

According to a second aspect of the present disclosure, there is provided a gain arrangement of a receiver path comprising the variable gain arrangement of any of the first aspect wherein the input signal received by the variable gain arrangement is a variable gain input signal and the output signal provided by the variable gain arrangement is a variable gain output signal, wherein the gain arrangement further comprises a fixed gain arrangement configured to receive a fixed gain input signal and apply a fixed gain to the fixed gain input signal to provide a fixed gain output signal wherein the fixed gain arrangement is arranged in series with the variable gain arrangement, the fixed gain arrangement comprising: a third input capacitor through which the fixed gain input signal is transmitted a second feedback capacitor arranged in series with the third input capacitor, wherein the gain applied by the fixed gain arrangement is based on a ratio of the capacitance of the second feedback capacitor and the third input capacitor; a second amplifier arranged in series with the third input capacitor wherein the second amplifier is further arranged in parallel with the second feedback capacitor and wherein the second amplifier is configured to provide the fixed gain output signal.

According to a third aspect of the present disclosure, there is provided a radar system comprising: a transmitter path configured to transmit a plurality of transmitted radar signals; a receiver path configured to receive a plurality of reflected radar signals, wherein the receiver path comprises the gain arrangement of the second aspect.

According to a fourth aspect of the present disclosure, there is provided an automotive vehicle comprising the radar system of claim 11.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1A shows an example embodiment of a gain arrangement of the present disclosure;
Figure 1B shows an example embodiment of the gain arrangement of Figure 1A after a gain change;
Figure 2 shows an alternative example embodiment of a gain arrangement according to the present disclosure;
Figure 3 shows yet a further alternative example embodiment of a gain arrangement of the present disclosure;
Figure 4 shows an example radar system according to the present disclosure; and
Figure 5 shows an example automotive vehicle comprising a radar system according to the present disclosure.

### Detailed Description

The proliferation of automotive radar in recent years has been significant and is expected to continue and accelerate, driven by factors like increasing safety regulations and a growing demand for Advanced Driver-Assistance Systems (ADAS) features as radar sensors become more advanced and more cost effective. Therefore, more emphasis will need to be placed on interference robustness. Radar signals transmitted by nearby vehicles may interfere with the desired reflected signals and even overload the receiver path of a radar receiver. One way to prevent overload is to lower the receiver gain so that more signal power can be handled before reaching compression. However, to maintain the same Signal-to-Noise ratio (SNR) this requires a lowering of the noise floor which can only be realized at cost of a significant increase of receiver supply power. Increase of supply power is conflicting with the wish to add more functionality on the same silicon die.

Instead of increasing supply power, it is possible to also increase interference robustness by detecting the arrival of an interference and, in response, reducing the receiver gain. Temporarily reducing the receiver gain increases power by very small amount and therefore is a more economical solution. Note that the receiver gain reduction will cost some SNR but only for the duration of the interference. The presence of a blocker signal will make it much more difficult to extract the reflected signals from underneath the blocker signal and, as such, losing some SNR does not impact the operation of the radar system significantly.

Since in-band blocking signals may arrive in fast bursts, the required gain changes also need to be made very quickly. In a typical intermediate frequency amplifier, a receiver gain can be changed by switching the ratio of an input capacitor and a feedback capacitor of the circuit. Unfortunately, a gain change disturbs the DC equilibrium of the capacitors and those need to settle for proper operation. The charge equilibrium is not a large problem with respect to DC content, however, it can cause issues with low-frequency signals, such as those that might arise from the reflection of a radar signal from a bumper of a vehicle. What can be exploited is that a gain change only involves a change of the magnitude of the transfer function, but not of the phase. Then, in the time domain, a gain change only involves a scaling of the output signal to a lower or higher value. The new output signal magnitude can be calculated from the amount of gain change and the value of the instantaneous output signal just before the gain switch.

While examples are provided herein of the challenges faced in automotive radar systems, it will be appreciated that any gain arrangement that adjusts its gain based on the ratio of the capacitances of two capacitors in the circuit may also suffer from undesirable settling effects. As such, the solution provided herein may be applicable in a range of technology areas, such as AM radio, but may have particular benefits in the field of automotive radar systems.

In the context of radar systems, such as frequency modulated continuous wave (FMCW) radar systems, the receiver path typically comprises a low-noise amplifier (LNA), a mixer, a base-band amplifier/filter and an analog-to-digital converter (ADC). The received FMCW radar intermediate frequency signal has an uneven spectral distribution, with relatively strong signals at low frequencies (>10kHz) which gradually taper off to weaker signals at higher frequencies (<40MHz). To equalise the spectral content, a cascade of two high-pass filter stages can be used between the mixer and the ADC. These filter stages also provide the gain to keep the ADC noise contribution low and, as such, provide the functionality of a gain arrangement.

In the context of FMCW radar systems, since the gain arrangements connect directly to a mixer output, it may be advantageous to have a low noise. To provide this, a substantially "noiseless" capacitive feedback arrangement can be used. The gain is set by the ratio of an input capacitor to a feedback capacitor of the arrangement. High-pass filtering may also be provided by a resistor arranged in parallel with the feedback capacitor.

FMCW radars work with so called chirps that periodically need to return to their initial frequency. During this return, the radar is not transmitting any signal and the receiver also does not need to receive any reflected signals. During the period in which the frequency of the transmit signal is returning to its starting value, the gain arrangement/intermediate frequency amplifier may be set to a reset mode. When a new chirp starts, the reflected signals abruptly reappear at the gain arrangement input as an input signal. The abruptness induces an unwanted transient component in the intermediate frequency amplifier that needs to die out. The transient settling can be considered to be a separate signal that disturbs the reception of the desired signals. For example, for a chirp having a total duration of 20 ps, the settling time may be approximately 4 µs.

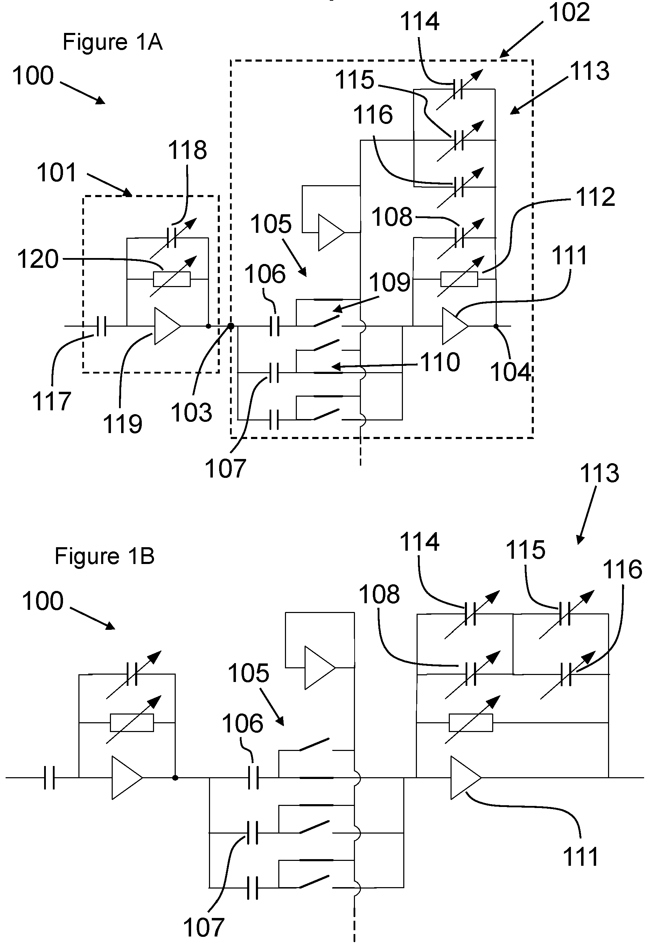

Figures 1A shows an example gain arrangement 100 according to the present disclosure. The gain arrangement comprises a fixed gain 101 arrangement (we then need to remove the arrows showing in the feedback resistor 120 and capacitor 118) and a variable gain arrangement 102.

The variable gain arrangement 102 of the present disclosure is the variable gain arrangement 102 of a receiver path. The receiver path may be a receiver path of any device which receives an input signal and to which a gain must be applied using an arrangement as provided for herein. For example, the receiver path may be the receiver path of an FMCW radar system but may also be the receiver path of a different type of radar system or a wireless communication device, for example.

The variable gain arrangement 102 is configured to receive an input signal and apply a gain to the input signal to provide an output signal. The gain is applied to the input signal by way of the components of the circuit (the variable gain arrangement 102) which interact with the input signal as it passes therethrough. The input signal may be considered to be the signal that is received at an input node 103 of the variable gain arrangement and the output signal may be considered to be the signal that is provided at an output node 104 of the variable gain arrangement. As the input signal passes through the variable gain arrangement 102, the signal will be impacted by the components through which it passes. Despite these changes, the input signal will be referred to as the input signal herein until it is provided as the output signal at an output node of the arrangement. It will be appreciated that, alternatively, however, the signal could be referred to as an intermediate signal or could take alternative nomenclature to denote its position or form as it passes through the variable gain arrangement 102 to the output node 104.

The variable gain arrangement 102 comprises an input capacitor arrangement 105 through which the input signal is transmitted. The input capacitor arrangement 105 comprises a first input capacitor 106 and may comprise a second or any number of input capacitor 107 arranged in parallel with the first input capacitor 106. The first and second input capacitors 106, 107 may have different capacitances. The input capacitors 106, 107 of the input capacitor arrangement 105 are switchably arranged such that the input signal is transmitted through only one of the input capacitors 106, 107 at a time. In one or more embodiments, it is also possible that capacitors are added cumulatively rather than that only one capacitor is selected at a time. The input capacitor 106, 107 through which the input signal is transmitted may be referred to as the input coupling capacitor of the input capacitor arrangement. The non-coupled input capacitor, the input capacitor through which the input signal is not transmitted, may be coupled to a first voltage. The first voltage may be any suitable voltage that equals the DC voltage present at input node of amplifier 111 and, for example, may be a common mode voltage. The common mode voltage may be provided by one or more amplifiers each having their output node coupled to their own input node.

The capacitance of the first input capacitor 106 and the second, third etc input capacitor 107 may be different. Since the gain applied by the variable gain arrangement is based on the ratio of the input coupling capacitor and a feedback capacitor 108, switching between the first and second input capacitors 106, 107 may provide for the variable gain functionality of the variable gain arrangement 102.

In one or more embodiments, such as the embodiment of figure 1, the coupled input capacitor may comprise three or more input capacitors which are switchable between such that the functionality of coupled input capacitor is provided by one of the capacitors of the plurality of at least three input capacitors.

In further detail, the input capacitor arrangement may comprise a first input path 109 which comprises the first input capacitor 106 and a second input path 110 which comprises the second input capacitor 107. The first input path 109 is arranged in parallel with the second input path 110 and the first and second input paths 109, 100 are switchable between. In particular, the first and second input paths 109, 110 may both be switchable between being connected to: an amplifier 111 and the feedback capacitor 108; and a first voltage, such as a common mode voltage. In embodiments with three or more input capacitors which are switchable between, there may be corresponding three or more input paths.

The variable gain arrangement 102 comprises a gain switching apparatus configured to provide for adjustment of the gain applied to the input signal by changing the ratio of the capacitance of the feedback capacitor and the first input capacitor. Providing for an input capacitor arrangement that comprises a plurality of input capacitors which can be switched between provides a single way of adjusting the gain applied by the variable gain arrangement 102. In such embodiments, the gain switching apparatus is the input capacitor arrangement. In other embodiments, however, the gain switching apparatus may be provided by one or more other combinations of components. For example, instead of providing only a single feedback capacitor 108, a feedback capacitor arrangement may be comprised which comprises at least the first feedback capacitor 108, a second feedback capacitor and a coupled feedback capacitor wherein the first and second feedback capacitors are switchably arranged such that the functionality of the coupled feedback capacitor is switchably provided by one of the first input capacitor and the second input capacitor. In yet other embodiments, the variable gain arrangement 102 may comprise both an input capacitor arrangement and a feedback capacitor arrangement such that the gain applied to the input signal can be adjusted by changing which input capacitor is the coupled input capacitor, changing which feedback capacitor is the coupled feedback capacitor or changing both the coupled input and coupled feedback capacitors.

The variable gain arrangement 102 further comprises a feedback capacitor 108 arranged in series with the input capacitor arrangement 105. It is the ratio between this feedback capacitor 108 and the coupled input capacitor that defines the voltage gain applied by the variable gain arrangement 102.

The variable gain arrangement 102 comprises an amplifier 111 arranged in series with the input capacitor arrangement 105 and in parallel with the feedback capacitor 108. By way of its positioning in the variable gain arrangement 102, the amplifier 111 provides the output signal. That is, the output node 104 of the variable gain arrangement 102 may be an output node of the amplifier 111.

The variable gain arrangement may further comprise a first resistor 112 which is arranged in parallel with both the feedback capacitor 108 and the amplifier 111 but in series with the input capacitor arrangement 105, as shown in figure 1A. The first resistor may provide for the filtering of low frequency signals in order to provide high-pass filter functionality to the variable gain arrangement 102.

The variable gain arrangement 102 further comprises a transient compensation capacitor arrangement 113. The transient compensation capacitor arrangement 113 comprises at least a first transient compensation capacitor 114. Upon a change of the gain of the variable gain arrangement 102, the at least one transient compensation capacitor 114 is configured to be coupled to or decoupled from the feedback capacitor 108 such that transient settling effects caused by the gain change are compensated for. That is, by providing for one or more transient compensation capacitors in a transient compensation capacitor arrangement 113 which can be selectively coupled to and decoupled from the feedback capacitor 108, a charge balance can be implemented which provides for transient compensation, thereby removing the need to wait for settling of one or more transient signals induced by the sudden gain change. When not coupled to the feedback capacitor 108, the one or more transient compensation capacitors may be coupled to the first voltage or to another voltage different to the first voltage. By being coupled to the voltage, the one or each transient compensation capacitor can be charged such that, upon connection to the feedback capacitor 108, the charge on the one or more transient compensation capacitors provide for the charge-balance necessary to compensate for the production of any undesired transient signals.

In the example of Figure 1A, the transient compensation capacitor arrangement comprises three transient compensation capacitors 114, 115, 116 which are coupled to the first voltage, which may be a common mode voltage. It will be appreciated that, in this embodiment, the number of transient compensation capacitors may be any plurality of transient compensation capacitors and does not specifically need to be three transient capacitors. By coupling these transient compensation capacitors to the first voltage, they are charged when not otherwise coupled to the feedback capacitor.

The example of Figure 1B shows a case where the coupled capacitor of the input capacitor arrangement 105 has been changed by coupling the first input capacitor 106 to the amplifier 111 and decoupling the second input capacitor 107 therefrom. Since the capacitances of the first input capacitor 106 and the second input capacitor 107 are different, the change in the input capacitor which is defined as the coupled capacitor results in a change in the gain of the variable gain arrangement. In response to the change of the gain of the variable gain arrangement, the interconnections of the transient compensation capacitors 114, 115, 116 are adjusted such that they are decoupled from the first voltage and are, instead, coupled to the feedback capacitor 108. The coupling of the transient compensation capacitors 114, 115, 116 to the feedback capacitor 108 provides for a balancing of the necessary charges and, thereby, compensation for any transient signals which might otherwise arise and need to settle resulting from the sudden gain change of the variable gain arrangement 102. Note that the example of figures 1A and 1B were laid out for a gain change of 2x. Note that, while the resistor and transistors are depicted in these figures as being variable components, in the context of implementing the transient free gain change, these components will remain constant. A general condition that may be fulfilled for the gain change by capacitor re-distribution applicable to Figure 1A and Figure 1B (and vice versa) may be:
a) The ratio of effective capacitance Cfb/Cs should match old/new gain requirement; and
b) The voltage across the Cfb capacitor after re-distribution should track the gain change.

Where Cfb is the total feedback capacitor capacitance and Cs the capacitance of the input coupling capacitor.

Figures 1A and 1B also shows a fixed gain arrangement (FGA) 101 which may comprise part of the overall gain arrangement 100. The fixed gain arrangement 101 comprises a FGA input capacitor 117, which may alternatively be referred to as the input capacitor of the fixed gain arrangement 101. The fixed gain arrangement 101 further comprises a FGA feedback capacitor 118, which may alternatively be referred to as the feedback capacitor of the fixed gain arrangement 101. The ratio of the FGA input capacitor 117 and the FGA feedback capacitor 118 define the gain applied by the fixed gain arrangement. The fixed gain arrangement 101 further comprises a FGA amplifier 119 arranged in series with the FGA input capacitor 117 and in parallel with the FGA feedback capacitor 118. The fixed gain arrangement 101 may further comprise an FGA resistor 120 wherein the FGA resistor 120 is arranged in parallel with both the FGA feedback capacitor 118 and the FGA amplifier 119. The FGA resistor 120 is also arranged in series with the FGA input capacitor 117. The FGA resistor 120 provides for equivalent high pass filtering as the first resistor.

The fixed gain arrangement 101 is arranged in series with the variable gain arrangement 102. Providing the variable gain arrangement 102 second in the series arrangement of gain arrangements may provide for an improved (reduced) signal-to-noise ratio in comparison to reversing the order of the gain arrangements. While the fixed gain arrangement 101 is arranged before the variable gain arrangement 102 in the examples of figures 1A and 1B, the fixed gain arrangement 101 may alternatively be arranged after the variable gain arrangement 102.

While the embodiment represented in figures 1A and 1B are functional, they are not necessarily preferable, as every gain that is required to be compensated for requires a different configuration of the transient settling capacitors 113, thereby requiring significant switching capabilities and increased numbers of transient settling capacitors 113, 114, 115.

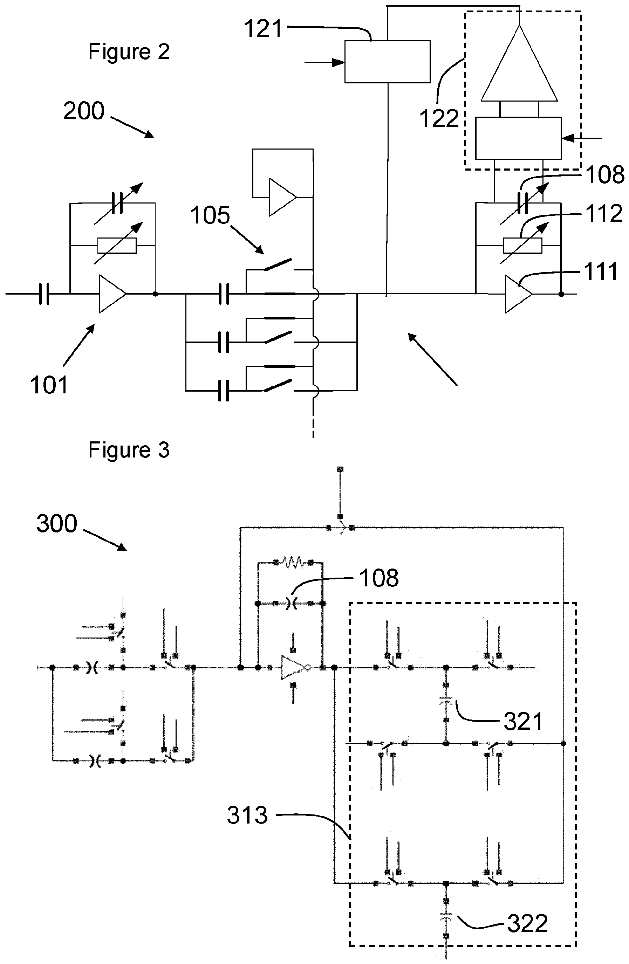

Figure 2 shows an embodiment of a gain arrangement 200 which comprises a fixed gain arrangement 101 which is equivalent to that described with reference to figures 1A and 1B. The variable gain arrangement 102 of figure 2 also comprises an input capacitor arrangement 105, feedback capacitor 108, amplifier 111 and first resistor 112 which are also analogous to that described with reference to figures 1A and 1B. For brevity, features which are in common between figures 1A, 1B and 2 will not be described again here.

The transient compensation capacitor arrangement of some embodiments, such as in the embodiment of figure 2, may comprise a transient compensation capacitor 121 which is a current injection component 121 which is configured to inject a required amount of charge onto the feedback capacitor 108. The current injection component may be a current injection capacitor 121, as in the embodiment of figure 2, or any other component which is suitable for injecting a required amount of charge. The current injection capacitor 121 is coupled to a first voltage, such as a common mode voltage, and is switchably couplable to the feedback capacitor 108. In particular, the transient compensation capacitor 121 is switchably couplable to a first node of the feedback capacitor. Upon an increase in the gain of the variable gain arrangement 102, the current injection capacitor 121 is configured to be coupled to the feedback capacitor 108 such that charge injected into the feedback capacitor 108 induces an output voltage correction that minimizes the transient settling effects. In one or more embodiments, the current from 121 is injected into feedback capacitor 108 for a predetermined amount of time wherein the predetermined amount of time is based on the change in gain that the variable gain arrangement 102 applies to the input signal in order to provide the output signal.

The variable gain arrangement may comprise a polarity switching arrangement. The polarity switching arrangement may be configured to provide for a switching of the polarity of charge applied to the feedback capacitor 108. The polarity switching arrangement may comprise four switches provided around the current injection capacitor which are configured to provide for a changing of the polarity of the charge provided by the current injection capacitor 121. In other embodiments, however, where the variable gain arrangement 102 is configured to compensate for gain changes from high-to-low, such a four-switch may not be necessary and, instead, only two switches may be used to switchably connect the current injection capacitor between a first voltage, such as a common mode voltage, and the current injection capacitor 121.

The variable gain arrangement 102 may further comprise a sample-and-hold arrangement 122. The sample-and-hold arrangement 112 may be arranged in parallel with the feedback capacitor 108 and may have an output which is coupled to the current injection capacitor 121. The sample-and-hold arrangement 122 may be configured to provide a required charged to the current injection capacitor 121. The sample-and-hold arrangement 122 may allow the current injection capacitor 121 to effectively track the output voltage. The sample-and-hold arrangement 122 is provided herein as an example, however, it will be appreciated that any suitable circuitry that allows for the current injection capacitor 121 to be suitably charged for providing current injection suitable to compensate for transient effects may be utilised. The sample-and-hold arrangement 122 may be used to sample signal conditions (such as the voltage of the output signal) just before a change in gain is enacted. The sample-and-hold arrangement 122 may be configured to use the sampled signal conditions to restore the signal conditions after the gain switch by providing for injection from the current injection capacitor 121 onto the feedback capacitor 108.

In further detail, the embodiment depicted in figure 2 provides for charge supplementation to the feedback capacitor. As described with reference to figures 1A and 1B, the gain switching is accomplished by changing the coupled input capacitor while the feedback capacitor remains fixed. As previously discussed, other methods may be used to adjust the ratio of the capacitance of the input capacitor(s) and the feedback capacitor(s). In this example, changing the capacitance of the coupled input capacitor from 6pF to 1.5pF reduces gain of the second stage by a factor of 4. A four times gain reduction requires that the output voltage abruptly becomes four times smaller. The conservation of charge of the feedback capacitor will resist the abrupt step. By injecting a defined amount of (positive or negative) charge, it is possible to substantially instantly correct the voltage across the feedback capacitor to the desired magnitude value. The correction is near instantaneous, as the time needed to supplement the charge can be much shorter than the variable gain arrangement settling time, effectively removing the need for settling. The correcting charge can be derived from the voltage across the feedback capacitor which can be captured with a sample and hold circuit arrangement at time t1, the moment just before a change in amplifier gain is initiated by a change of the coupled input capacitor. The corrective charge is then derived from the sampled volage, amplified by either + or - 1 (depending on the direction of the gain change), and the current injection capacitor that converts the voltage into a charge. The correcting charge as defined by the product of the sampled voltage over the feedback capacitor, the sign and the capacitance of the injection capacitor is injected into the amplifier input at time t2. Time t2 occurs immediately following the sampling moment t1. Figure 8 gives an overview of the correcting charge required when stepping down the gain with a factor by a factor of four and when stepping it up by a factor of four. For the first case, the charge correction is -0.75 multiplied by the capacitance of the feedback capacitor and, in the second case, +3 multiplied by the capacitance of the feedback capacitor. It should be noted that charge needs to be taken out of the feedback capacitor when reducing gain while charge needs to be added when increasing the gain. In one or more embodiments, the input capacitors which are not coupled the coupled input capacitor may be pre-charged by keeping them connected to a first voltage, such as the common mode voltage.

Figure 3 shows an embodiment of a gain arrangement 300 which comprises a fixed gain arrangement which is equivalent to that described with reference to figures 1A and 1B. The variable gain arrangement 102 of figure 2 also comprises an input capacitor arrangement 105, feedback capacitor 108, amplifier 111 and first resistor 112 which are also analogous to that described with reference to figures 1A and 1B. For brevity, features which are in common between figures 1A, 1B and 3 will not be described again here.

The embodiment of figure 3 shows an example gain arrangement 300 in which transient compensation capacitor arrangement 313 comprises both a first current injection capacitor 321 and a second current injection capacitor 322. The first injection current capacitor 322 is configured to, upon its connection to the feedback capacitor, inject current into feedback capacitor 108. Similarly, the second injection current capacitor 321 is configured to, upon its connection to the feedback capacitor 108, inject current into capacitor 108 having the opposite polarity. By providing the first and second current injection capacitors, the circuit is able to compensate for both low-to-high gain changes and high-to-low gain changes.

Figure 3 shows an example of the polarity inversion arrangement that comprises four switches that allows for the provision of reversing the polarity of charge that is provided from the second current injection capacitor 321 to the feedback capacitor 108. The second current injection capacitor 322 does not require a reversal of its polarity and, as such, two switches are sufficient to selectively couple the second current injection capacitor 322 to the feedback capacitor 108. It will be appreciated that, in other embodiments, different numbers of switches may be suitable for providing for the selective coupling of either or both of the first current injection capacitor 321 and the second current injection capacitor 322 to the feedback capacitor 108.

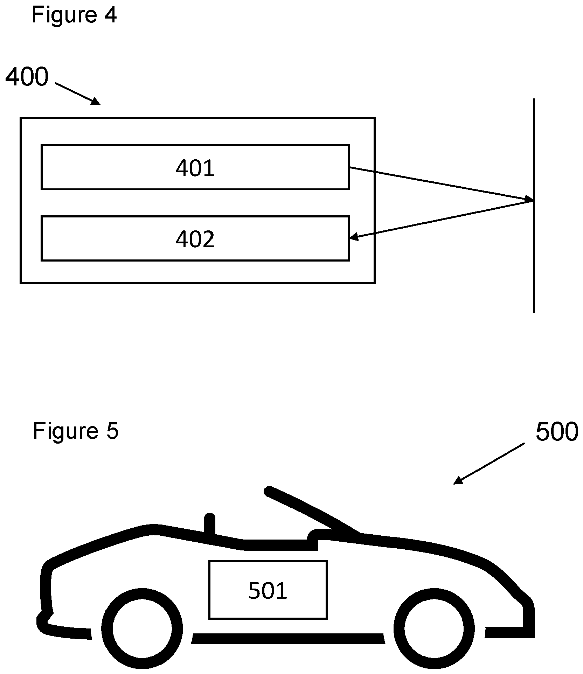

Figure 4 shows an example radar system 400 which comprises a transmitter path 401 configured to transmit a plurality of radar signals. The radar system 400 further comprises a receiver path 402 configured to receive a plurality of reflected radar signals, wherein the receiver path 402 comprises a gain arrangement as described with reference to figures 1A, 1B, 2 and 3. The radar system 400 may be any suitable radar system 400 in which transient settling effects resulting from sudden gain changes on the receiver path may be undesirable. For example, the radar system 400 may be an automotive radar system.

Figure 5 shows an example automotive vehicle 500 comprising the radar system 501 described with reference to figure 4. While figure 5 depicts a car 500, it will be appreciated that the vehicle may be any automotive vehicle which can benefit from an installed radar system 501. For example, the automotive vehicle 500 may be a car, a van, a lorry, a bus, a construction vehicle or any other vehicle which may share a road with other vehicles are traversing. The radar system 501 may further be used in vehicles 500 which do not use roads but that might have other obstacles that need to be navigated, such as boats or ships.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A variable gain arrangement of a receiver path configured to receive an input signal and apply a gain to the input signal to provide an output signal, the variable gain arrangement comprising:
an input capacitor arrangement through which the input signal is transmitted comprising a first input capacitor;
a feedback capacitor arranged in series with the input capacitor arrangement, wherein the gain applied by the variable gain arrangement is based on a ratio of the first input capacitor and the capacitance of the feedback capacitor and
a gain switching apparatus configured to provide for adjustment of the gain applied to the input signal by changing the ratio of the capacitance of the feedback capacitor and the input capacitor arrangement;
an amplifier arranged in series with the input capacitor arrangement, wherein the amplifier is further arranged in parallel with the feedback capacitor and wherein the amplifier is configured to provide the output signal; and
a transient compensation capacitor arrangement comprising at least a first transient compensation capacitor,
wherein, upon a change in the gain of the variable gain arrangement, the at least one transient compensation capacitor is configured to be coupled to or decoupled from the feedback capacitor such that transient settling effects caused by the gain change are compensated.

2. The variable gain arrangement of claim 1 wherein the input capacitor arrangement is the gain switching apparatus and wherein the input capacitor arrangement further comprises:
a second input capacitor arranged in parallel with the first input capacitor; and
a coupled input capacitor wherein the coupled input capacitor is the capacitor through which the input signal is transmitted, wherein the first input capacitor and the second input capacitor are switchably arranged such that the functionality of the coupled input capacitor is switchably provided by one of the first input capacitor and the second input capacitor.

3. The variable gain arrangement of claim 1 wherein the transient compensation capacitor arrangement comprises a plurality of transient compensation capacitors wherein, upon a change in the gain applied by the variable gain arrangement, the interconnections of the plurality of capacitors of the transient compensation capacitor arrangement with the feedback capacitor are dynamically reconfigured in order to provide for the transient settling effect compensation.

4. The variable gain arrangement of claim 1 wherein the first transient compensation capacitor is a current injection capacitor switchably couplable to the feedback capacitor, wherein the current injection capacitor is configured to, upon a change in the gain of the output signal, be coupled to the feedback capacitor such that charge is injected onto the feedback capacitor wherein the charge injection provides for the transient settling effect compensation.

5. The variable gain arrangement path of any of claims 2-4 wherein the first input capacitor and the second input capacitor have different capacitances such that switching between the first input capacitor and the second input capacitor to define the coupled input capacitor causes the change in gain of the gain applied by the variable gain arrangement.

6. The variable gain arrangement of claim 5 wherein the input capacitor arrangement comprises:
a first input path which comprises the first input capacitor; and
a second input path which comprises the second input capacitor wherein
the first input path is arranged in parallel with the second input path and
wherein the first input path and the second input path are switchably couplable between:
the amplifier; and
a first voltage.

7. The variable gain arrangement of any preceding claim further comprising a filtering resistor arranged in parallel with both the amplifier and the feedback capacitor wherein the filtering capacitor is configured to provide low frequency filtering of the input signal.

8. The variable gain arrangement of any of claim 4 to claim 7 wherein the current injection capacitor is coupled to the first voltage such that, when not coupled to the feedback capacitance arrangement, the injection capacitor is charged by the first voltage.

9. The variable gain arrangement of any of claim 4 to claim 8 wherein the current injection capacitor is a first current injection capacitor coupled to a first node of the feedback capacitor and wherein the transient compensation capacitor arrangement comprises a second current injection capacitor coupled to a second node of the feedback capacitor, wherein the second a current injection capacitor is switchably couplable to the feedback capacitor, wherein:
in response to an increase of the gain of the variable gain arrangement, the feedback capacitor is configured to be coupled to the feedback capacitor; and
in response to a decrease of the gain of the variable gain arrangement, the second feedback capacitor is configured to be coupled to the feedback capacitor.

10. A gain arrangement of a receiver path comprising the variable gain arrangement of any of claims 1 - 8 wherein the input signal received by the variable gain arrangement is a variable gain input signal and the output signal provided by the variable gain arrangement is a variable gain output signal, wherein the gain arrangement further comprises a fixed gain arrangement configured to receive a fixed gain input signal and apply a fixed gain to the fixed gain input signal to provide a fixed gain output signal wherein the fixed gain arrangement is arranged in series with the variable gain arrangement, the fixed gain arrangement comprising:
a third input capacitor through which the fixed gain input signal is transmitted
a second feedback capacitor arranged in series with the third input capacitor, wherein the gain applied by the fixed gain arrangement is based on a ratio of the capacitance of the second feedback capacitor and the third input capacitor;
a second amplifier arranged in series with the third input capacitor wherein the second amplifier is further arranged in parallel with the second feedback capacitor and wherein the second amplifier is configured to provide the fixed gain output signal.

11. A radar system comprising:
a transmitter path configured to transmit a plurality of transmitted radar signals;
a receiver path configured to receive a plurality of reflected radar signals, wherein the receiver path comprises the gain arrangement of claim 10.

12. An automotive vehicle comprising the radar system of claim 11.
